(19) Europäisches Patentamt
European Patent Office
Office européen des brevets

(11) **EP 3 008 662 B1**

(12) **EUROPÄISCHE PATENTSCHRIFT**

(45) Veröffentlichungstag und Bekanntmachung des Hinweises auf die Patenterteilung:
**08.08.2018 Patentblatt 2018/32**

(51) Int Cl.:
***G06F 3/041*** *(2006.01)*　　　***G06F 3/042*** *(2006.01)*

(21) Anmeldenummer: **14738363.2**

(22) Anmeldetag: **21.05.2014**

(86) Internationale Anmeldenummer:
**PCT/DE2014/100176**

(87) Internationale Veröffentlichungsnummer:
**WO 2014/198259 (18.12.2014 Gazette 2014/51)**

(54) **VERFAHREN ZUR OPTISCHEN ERFASSUNG EINES FINGERABDRUCKS ODER EINES GEGENSTANDES UND VORRICHTUNG MIT MINDESTENS EINEM BILDSCHIRM**

METHOD FOR OPTICALLY DETECTING A FINGERPRINT OR AN OBJECT, AND DEVICE WITH AT LEAST ONE SCREEN

PROCÉDÉ DE DÉTECTION OPTIQUE D'UNE EMPREINTE DIGITALE OU D'UN OBJET ET DISPOSITIF ÉQUIPÉ D'AU MOINS UN ÉCRAN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.06.2013 DE 102013106105**

(43) Veröffentlichungstag der Anmeldung:
**20.04.2016 Patentblatt 2016/16**

(73) Patentinhaber: **Hossu, Dan**
**55768 Welersbach (DE)**

(72) Erfinder: **Hossu, Dan**
**55768 Welersbach (DE)**

(74) Vertreter: **Müller, Jochen**
**Müller & Aue**
**Patentanwälte**
**Schwester-Steimer-Weg 4**
**55411 Bingen (DE)**

(56) Entgegenhaltungen:
**EP-A1- 1 158 775**　　　**WO-A1-2004/088627**
**CN-A- 103 105 978**　　**US-A1- 2004 252 867**
**US-A1- 2008 122 803**　**US-A1- 2010 201 275**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung bezieht sich auf ein Verfahren zur optischen Erfassung eines Fingerabdrucks oder eines Gegenstandes und eine Vorrichtung mit mindestens einem Bildschirm, der eine obere optische Abdeckplatte umfasst, unter der mehrere Anzeigepixel als Lichtquellen für das darzustellende Bild angeordnet sind.

Derartige Vorrichtungen sind als Anzeigevorrichtungen mit beliebig ausgestalteten Bildschirmen bekannt. Beispielsweise werden LED- oder vorzugsweise OLED-Bildschirme in mobilen Geräten zum Beispiel in sogenannten Smartphones oder Tablet-Computern als hochauflösende Touch-Screens eingesetzt. Als problematisch erweist sich beispielsweise die Datensicherheit bei der Verwendung solcher mobiler Geräte, die bei einem kompakten Aufbau keinen Platz zum Einbau beispielsweise eines FingerabdruckLesegerätes aufweisen.

Die EP 1 158 775 A1 und die US 2004/0252867 A1 offenbaren Erfassungs- und Anzeigeeinrichtungen mit lichtemittierenden und lichterfassenden Mitteln.

Fingerabdruck-Erkennungssysteme umfassen in der Regel kapazitive oder optische Flächensensoren zur Erfassung charakteristischer Merkmale einer Fingerkuppe. Die aufgenommenen Signale werden oftmals von einem Aufnahmegerät mit in einem Speicher hinterlegten Fingerabdruckmerkmalen berechtigter Personen verglichen. Stimmt der von dem FingerabdruckSensor aufgenommene Fingerabdruck mit einem hinterlegten Fingerabdruckmuster in wesentlichen Merkmalen überein, gibt das Aufnahmegerät ein entsprechendes Signal an eine Auswerte- und Steuereinrichtung, die beispielsweise ein Türschloss entriegelt. Versucht beispielsweise ein Unberechtigter sich Zugang zu verschaffen, wird dies bei einem Vergleich der aufgenommenen Fingerabdruckmerkmale des Unberechtigten mit den gespeicherten Fingerabdruckmerkmalen erkannt und eine Signalübertragung an die Auswerte- und Steuereinrichtung entweder unterdrückt oder ein Fehlversuchsignal übertragen.

Im Weiteren zeigt die DE 699 20 126 T2 ein Fingerabdrucklesegerät mit einer Lichtquelle, einer Fotosensoreinrichtung, die mehrere auf der Lichtquelle ausgebildete Fotosensoren sowie eine auf den Fotosensoren ausgebildete Oberfläche umfasst, und einer auf der Fotosensoreinrichtung ausgebildeten durchsichtigen, lichtleitenden Schicht. Problematisch ist die Anordnung eines solchen Fingerabdrucklesegerätes insbesondere bei einem sogenannten Smartphone oder einem Tablet-Computer, da hier wenig Platz in einem Gehäuse als Einbauraum zur Verfügung steht aber eine relativ hohe Datensicherheit und damit eine wirksame Zugangskontrolle erwünscht ist.

Darüber hinaus ist ein oberflächen-kapazitiver Touchscreen bekannt, der im Wesentlichen eine mit einem durchsichtigen Metalloxid beschichtete Folie, die auf eine transparente Trägerplatte, meistens Glas, laminiert ist. An den Ecken der Beschichtung wird eine Wechselspannung angelegt, um ein elektrisches Feld zu erzeugen. Bei einer Berührung entsteht ein geringer Ladungstransport, der im Entladezyklus in Form eines Stromes an den Ecken gemessen wird. Die resultierenden Ströme aus den Ecken stehen im direkten Verhältnis zu der Touch-Position.

Der Erfindung liegt die Aufgabe zugrunde, ein Verfahren und eine Vorrichtung der eingangs genannten Art zu schaffen, das bzw. die sowohl eine Anzeigefunktion als auch eine Lesefunktion ermöglicht.

Erfindungsgemäß wird die Aufgabe durch die Merkmale der unabhängigen Ansprüche gelöst.

Die Unteransprüche stellen vorteilhafte Ausgestaltungen der Erfindung dar.

Bei einem Verfahren zur optischen Erfassung eines Fingerabdrucks oder eines Gegenstandes auf einer Oberfläche einer Abdeckplatte eines Bildschirms mit mehreren Fotosensoren, die jeweils einem Anzeigepixel zugeordnet sind, emittieren die Anzeigepixel Lichtstrahlung und die Fotosensoren erfassen innerhalb eines Abtastwinkels von der Oberfläche reflektierte Lichtstrahlung der Anzeigepixel, wobei die Größe des Abtastwinkels des Fotosensors derart bestimmt wird, dass sie die Größe des Anzeigepixels in einer virtuellen Spiegelbildebene, die durch die Spiegelung des Anzeigepixels an der Oberfläche der Abdeckplatte entsteht, erfasst.

Die Spiegelung des Anzeigepixels an der Oberfläche der Abdeckplatte bestimmt die Größe des Abtastwinkels des Fotosensors, wobei durch den Abtastwinkel die Größe des Anzeigepixels in der virtuellen Spiegelbildebene zu beschreiben ist. Die Anzeigepixel des Bildschirms dienen zur Darstellung eines Bildes in der Bildschirmfunktion und zur Beleuchtung eines Fingers oder sonstigen zu scannenden Gegenstandes in der Fingerabdruckerkennungs- oder Scan-Funktion. Der Fotosensor ist in seinem Abtastwinkel an die Größe des Anzeigepixels angepasst. Wenn das Anzeigepixel sich selbst spiegelt, sich also auf der Abdeckplatte im Bereich des Abtastwinkels des Fotosensors Luft befindet, wird ein größerer Anteil der emittierten Lichtstrahlung von dem Fotosensor empfangen und lediglich ein geringerer Anteil hinter die Oberfläche der Abdeckplatte gesendet. Bei einem aufgelegten Finger wird nur ein geringerer Anteil der emittierten Lichtstrahlung reflektiert und von dem Fotosensor empfangen und aufgrund der optischen Ankopplung ein größerer Anteil der Lichtstrahlung hinter der Oberfläche von dem Finger absorbiert. Bei dem Übergang Abdeckplatte-Luft wird etwa 4% zurückreflektiert und bei einem auf die Abdeckplatte aufgelegten Finger weit unter 1%. Die Nähe des Anzeigepixels wirkt, dass hier die 4% sehr viel Licht bedeuten, wesentlich mehr als von einem z. B. gescannten Objekt hinter der Oberfläche reflektiert würde.

Bei der Scan-Funktion werden bestimmte Subpixel der Anzeigepixel zum Emittieren von Lichtstrahlung angesteuert, wobei die diesen Anzeigepixeln zugeordneten Fotosensoren passiv sind und die aktiven Fotosensoren in benachbarten ausgeschalteten Anzeigepixeln erfassen teilweise die an dem Gegenstand, beispielsweise einem zu erfassenden Dokument, reflektierte Lichtstrahlung. Durch die Ansteuerung unterschiedlicher Anzeigepixel bzw. Subpixel zum Leuchten und Fotosensoren zum Erfassen reflektierte Lichtstrahlung entstehen Halbbilder, die entsprechend überlagert ein Gesamtbild des zu scannenden Dokuments ergeben. Würde der dem leuchtenden Anzeigeelement zugeordnete Fotosensor beim Scannen des Dokumentes eingeschaltet, dann besteht die Gefahr der Erfassung reflektierter Lichtanteile des eigenen Anzeigepixels, die eine unerwünschte Schleierbildung verursachen.

Eine Vorrichtung, insbesondere zur Durchführung des zuvor erläuterten Verfahrens, umfasst mindestens einen Bildschirm, mit einer oberen optischen Abdeckplatte, unter der mehrere Anzeigepixel als Lichtquellen für das darzustellende Bild angeordnet sind. Mehreren Anzeigepixeln ist jeweils mittig ein Fotosensor zugeordnet.

Die Anzeigepixel des Displays senden Licht unmittelbar durch die obere Abdeckplatte, die selbstverständlich transparent ist, zu deren äußerer Oberfläche. Der Fotosensor empfängt unter einem bestimmten Abtastwinkel Licht des ihm zugeordneten Anzeigepixels, das an der Oberfläche reflektiert, also gespiegelt wird.

Dementsprechend wird von der als Anzeigepixel ausgestalteten Lichtquelle, die eine beliebige, also auch beispielsweise eine infrarote Strahlung aussendet, im Auflichtverfahren zu der Oberfläche mit dem optisch abzutastenden Objekt, insbesondere einem Finger, und die von der Oberfläche reflektierte Lichtstrahlung zu dem Fotosensor übertragen. Die Übertragung der Lichtstrahlung erfolgt innerhalb des vorbestimmten Abtastwinkels des Fotosensors. Es wird hierbei die optische Eigenschaft der Abdeckplatte genutzt, dass am Ausgang der Lichtstrahl in das dort befindliche Medium anhand des Brechungsindex des Mediums besser oder schlechter einkoppelt, und dadurch weniger oder mehr Licht zurückreflektiert wird. Die menschliche Haut verhält sich wie ein Medium mit einem höheren Brechungsindex als die Luft. Durch das verwendete Auflichtverfahren kann die Vorrichtung Helligkeitsänderungen des reflektierten Lichts bei einer verhältnismäßig geringen Strahlungsintensität gegenüber der Durchlichtmethode besser registrieren. Die Erkennung von Objekten auf der Abdeckplatte bzw. dem Bildschirm kann beispielsweise als Steuerungsfunktion verwendet werden. Der Touch-Screen funktioniert bei der Anordnung von über den gesamten Bildschirm verteilten Fotosensoren und nicht kapazitiv, wie aus dem Stand der Technik bekannt ist, wobei selbstverständlich nach einer entsprechenden Oberflächenbeschichtung und dem Anlegen sowie Überwachen einer entsprechenden Spannung selbstverständlich auch diese Funktion nicht ausgeschlossen ist.

In Ausgestaltung sind die Fotosensoren in einem mittigen Freiraum des zugeordneten Anzeigepixels, insbesondere umgeben von Subpixeln, oder auf der der Abdeckplatte gegenüberliegenden Seite der Anzeigepixel angeordnet. Bei einer Anordnung der Fotosensoren hinter den Anzeigepixeln, also auf der der Abdeckplatte gegenüberliegenden Seite kann eine im Wesentlichen bekannte Anzeigeeinrichtung, beispielsweise ein OLED, ohne wesentliche Änderungen verwendet werden. Im Zusammenhang mit einem OLED ergibt sich der weitere Vorteil, dass die Anbringung des anzeigepixelbezogenen Fotosensors die Messung der Helligkeit und Farbverschiebung jeden einzelnen Anzeigepixels und Subpixels erlaubt. Eine geeignete Auswerteeinheit kann anschließend die Helligkeit der Subpixel korrigieren. Das ermöglicht eine einfache und günstige Lösung der unterschiedlichen Alterung der Subpixel eines OLED, dessen Farben bekannterweise einer unterschiedlichen Alterung unterliegen. Bevorzugt ist die Messung des eigenen Anzeigepixels, in dem Fingerprint-Modus, da hier die tatsächliche Farbe durch den eigenen Fotosensor gemessen wird. Eine Messung der Hintergrundfarbe mit abgeschalteten Anzeigepixeln und die Einbeziehung dieser Werte in der Auswertung erhöht die Messgenauigkeit. Die Verwendung eines Objekts für die Kalibrierung, z. B. ein Blatt weißes Papier oder ein graues Objekt, kann ebenfalls zur Kalibrierung verwendet werden. In diesem Fall wird das Papier oder das Objekt in Scan-Modus erfasst.

Vorzugsweise emittiert mindestens eines der Anzeigepixel oder ein Subpixel des Anzeigepixels Strahlung im Infrarot- oder Ultraviolettbereich. Bei der Anordnung eines im Infrarotbereich Licht emittierenden Anzeigepixels ist die Erfassung einer Position eines Objekts, beispielsweise eines Fingers, möglich. Insbesondere für Sicherheitsapplikationen können auch im UV-Bereich emittierende Anzeigepixel vorgesehen sein.

Alternativ oder zusätzlich emittieren bevorzugt die Anzeigepixel oder ein Subpixel monochromes oder farbiges Licht. Bei dem monochromen Licht kann es sich beispielsweise um rotes, grünes oder blaues oder auch infrarotes Licht handeln.

Zweckmäßigerweise umfasst jedes Anzeigepixel mehrere Subpixel. Die Subpixel können beispielsweise um den Fotosensor angeordnet sein.

Um einen relativ dünnen Bildschirm bereitzustellen, sind die Anzeigepixel Bestandteile eines OLED.

Nach einer Weiterbildung umfasst jeder Fotosensor einen Farbfilter und/oder jedem Fotosensor ist eine, insbesondere metallisierte, Maske zur Abschirmung vor einer direkten Beleuchtung durch die Anzeigepixel zugeordnet. Um farbiges Licht zu erfassen, das reflektiert wird, ist es erforderlich, dass der Fotosensor drei Einzelempfänger mit jeweils einen Rot Grün Blau (oder komplementären Gelb Magenta Cyan) Farbfilter umfasst, insbesondere Sub-Fotosensoren. Die vorzugsweise metallisierte Maske dient zur Abschirmung des Fotosensors vor einer direkten Bestrahlung, da die Maske das fotoempfindliche Element im Schatten der Lichtquelle, also der Anzeigepixel hält. Vorzugsweise kann ein vierter Einzelempfänger des Fotosensors ohne Farbfilter die Infrarotstrahlung des entsprechend ausgebildeten Anzeigepixels getrennt erfassen.

Um das reflektierte Licht auf den zugeordneten Fotosensor zu bündeln, ist vorzugsweise jedem Fotosensor eine, bevorzugt als Fresnel-Linse oder holografische Linse ausgebildete, Mikrolinse zugeordnet ist. Die Anordnung bzw. Ausbildung einer Mikrolinse kann ab einer bestimmten Dicke der Abdeckplatte erforderlich werden, beispielsweise ab einer Dicken von 50 bis 100 μm. Zweckmäßigerweise ist die Mikrolinse zwischen der Abdeckplatte und dem Fotosensor angeordnet.

In weiterer Ausgestaltung sind zumindest die Anzeigepixel und die Fotosensoren mit einer Rechnereinheit und einem Speichermodul verbunden. Nach einer Weiterbildung ist eine mit dem Rechner gekoppelte Umschalteinrichtung vorgesehen, um entweder einen Fingerabdruckerkennungs-Modus, in dem sämtliche Anzeigepixel Lichtstrahlung emittieren und deren zugeordneten Fotosensoren reflektierte Lichtstrahlung erfassen, oder einen Scan-Modus, in dem die Anzeigepixel nacheinander schachbrettmusterförmig oder zeilen-/ spaltenförmig ein- und ausgeschaltet werden, um Lichtstrahlung zu emittieren, und die Fotosensoren der jeweils ausgeschalteten Anzeigepixel zum Empfangen der reflektierten Lichtstrahlung eingeschaltet werden. In beiden Modi kann die Position eines Fingers oder sonstigen Gegenstandes auf der Oberfläche der Abdeckplatte durch den Rechner ermittelt werden und die Touch-Screen-Funktionalität ist gewährleistet.

Um einen dünnen und bruchsicheren Bildschirm bereitzustellen, ist vorzugsweise die Abdeckplatte als eine flexible Kunststofffolie ausgebildet. Bevorzugt ist die Kunststofffolie unbeschichtet, hart beschichtet oder mit einer weiteren Folie, vorzugsweise einer Graphen-Folie, abgedeckt, und/oder besteht aus mehreren Lagen Folie. Entsprechende Beschichtungen, Laminate oder dergleichen sind dem Fachmann zum Schutz optischer Oberflächen bekannt. Graphen ist die Bezeichnung für eine Modifikation des Kohlenstoffs mit zweidimensionaler Struktur, in der jedes Kohlenstoffatom im Winkel von 120 ° von drei weiteren umgeben ist, so dass sich ein bienenwabenförmiges Muster ausbildet. Graphen-Fächenkristalle weisen eine hohe Steifigkeit und Festigkeit auf und schwächen Licht im sichtbaren Wellenlängenbereich nur geringfügig.

Bei einer Verwendung der zuvor erläuterten Vorrichtung als ein Fingerabdrucksensor und/oder ein Dokumentenscanner und/oder ein Touch-Screen für ein Mobiltelefon, ein Smartphone, einen Tablet-Computer oder einen stationären neuartigen Arbeitsbildschirm-Computer können beispielsweise Fingerabdrücke als eine Art Zugangsberechtigung gespeichert und mit einem gescannten Fingerabdruck auf dem Bildschirm verglichen werden. Es ist auch möglich, ein Dokument oder einen Bildschirm einer zweiten Vorrichtung zum Scannen auf die erste Vorrichtung aufzulegen bzw. in deren unmittelbaren Nahbereich zu bringen. Wie bereits geschildert, kann die Erfassung eines Fingerabdrucks oder eines sonstigen Gegenstandes auf dem Bildschirm auch zu dessen Positionsbestimmung verwendet werden, sodass der Bildschirm als Touch-Screen dient. Bei einem Großbildschirm, beispielsweise mit einer Bildschirmdiagonalen von 60" oder mehr, eines Arbeitsbildschirm-Computers, der wie ein Großfernseher flach auf dem Tisch liegt, ist es möglich, in einem Team zu arbeiten, wobei jedes Teammitglied, erkannt durch seinen Fingerabdruck, mit einer eigenen Applikation und Berechtigung arbeitet und gleichzeitig Dokumente zu scannen.

Die beschriebene Vorrichtung stellt einen Touch-Screen mit einem vielfach verwendbaren Scanner in einem Gerät dar, das relativ dünn aufgebaut und sowohl in einem mobilen Gerät als auch in einem stationären Gerät verwendbar ist. Die Vorrichtung ermöglicht das Scannen von Fingerabdrücken auf der Bildschirmoberfläche und dadurch eine Kopplung der Bildschirminhalte mit der Sicherheit durch das biometrische Merkmal des Fingerabdrucks. Im Weiteren lassen sich mit der Vorrichtung Dokumente und Gegenstände direkt auf der Bildschirmoberfläche scannen, wobei die Scans monochrom, farbig oder multispektral (zusätzlich IR und/oder UV) sein können. Darüber hinaus ermöglicht die Vorrichtung eine verhältnismäßig große und präzise "Multitouch-Fähigkeit" im Vergleich mit der kapazitiven Technologie nach dem Stand der Technik. Bei der Vorrichtung kann eine kostengünstige Kunststofffolie ebenso zum Einsatz kommen, wie ein gehärtetes Glas, sodass auch die Herstellung von bruchfesten und extrem leichten Mobilgeräten, insbesondere im Zusammenhang mit der Abdeckung aus Kunststoff möglich ist.

Die Vorrichtung ermöglicht die Verwendung von Software, insbesondere in Form sogenannter Apps, nur bei Vorliegen eines registrierten Fingerabdrucks, wodurch die Sicherheit in der Software impliziert ist, wenn diese mit einem Fingerabdruck gestartet werden muss. Eine weitere sicherheitsrelevante Anwendung ist beispielsweise das sichere Einkaufen im Internet durch eine vereinfachte Authentisierung, wobei diese in Kombination mit einer virtuellen Tastatur gesteigert werden kann, indem mehreren Zeichen der virtuellen Tastatur jeweils ein Fingerabdruck zugeordnet wird.

Mit der Vorrichtung sind kalibrierte Farbscans sowie der Aufbau einer "Farb-Datenbank" möglich, die Farben eigener Gegenstände, wie z. B. Kleidungsstücke, umfasst, die gescannt wurden. Diese "Farb-Datenbank" kann für den Einkauf farblich abgestimmter Gegenstände im Internet genutzt werden.

Werden zwei Vorrichtungen beziehungsweise Mobilgeräte mit integrierten Vorrichtungen mit ihren Bildschirmen im Wesentlichen ohne einen Spalt gegeneinander gehalten, können Daten über die zahlreichen optischen Sender/Empfänger, nämlich die Anzeigepixel und die Fotosensoren, abhörsicher ausgetauscht werden.

Es versteht sich, dass die vorstehend genannten und nachstehend noch zu erläuternden Merkmale nicht nur in der jeweils angegebenen Kombination, sondern auch in anderen Kombinationen verwendbar sind.

Der Rahmen der Erfindung ist nur durch die Ansprüche definiert.

Die Erfindung wird im Folgenden anhand von Ausführungsbeispielen unter Bezugnahme auf die zugehörige Zeichnung näher erläutert.

Es zeigt:

Fig. 1     eine schematische Darstellung eines Querschnitts durch eine Vorrichtung nach der Erfindung,

Fig. 2     eine schematische Darstellung eines Querschnitts durch eine Vorrichtung nach Fig. 1 in alternativer Ausgestaltung,

Fig. 3     eine Draufsicht auf die schematische Darstellung einer Einzelheit III nach Fig. 1,

Fig. 4     eine Draufsicht auf die schematische Darstellung einer Einzelheit III nach Fig. 1 in alternativer Ausgestaltung,

Fig. 5     eine schematische Darstellung eines Querschnitts durch eine Vorrichtung nach Fig. 1 in alternativer Ausgestaltung mit einem aufgelegten Finger und

Fig. 6     eine schematische Darstellung eines Querschnitts durch eine Vorrichtung nach Fig. 5 mit einem aufgelegten Dokument.

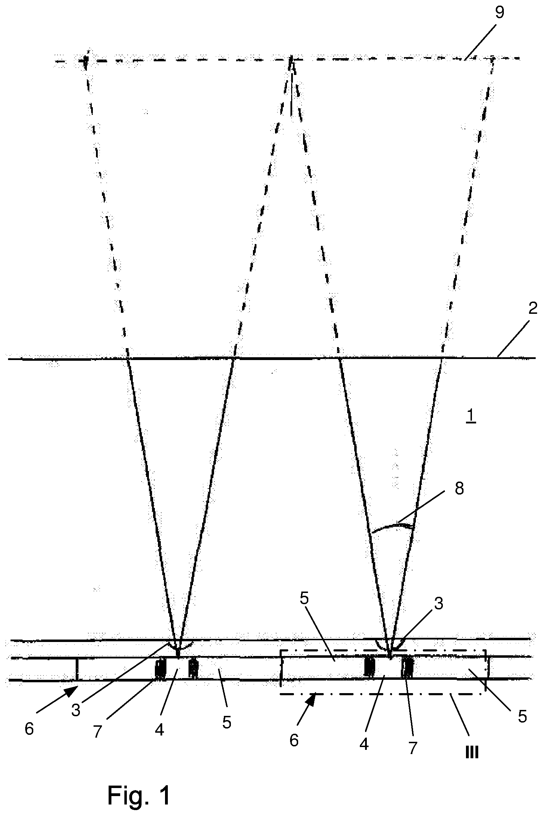

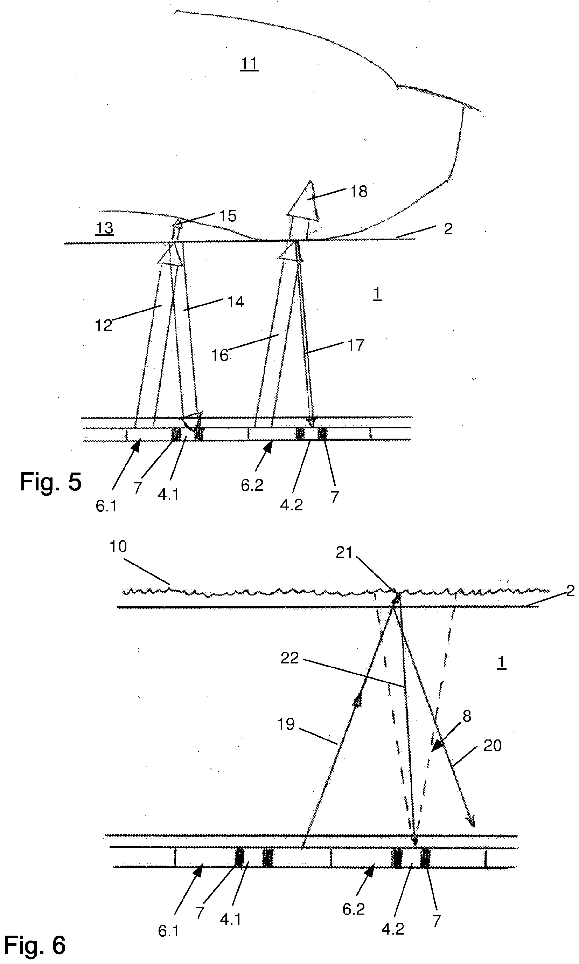

Die Vorrichtung gemäß Fig. 1 umfasst eine optische Abdeckplatte 1, auf deren Oberfläche 2 ein zu scannendes Objekt gelegt wird, insbesondere ein Dokument 10 oder Finger 11 zur Erfassung eines Fingerabdrucks, wobei die Abdeckplatte 1 aus Glas oder Kunststoff gefertigt, insbesondere als eine relativ dünne Kunststofffolie ausgebildet, sein kann. Auf der der Oberfläche 2 gegenüberliegenden Seite der Abdeckplatte 1 sind Mikrolinsen 3 vorgesehen, die einer hinreichend dünnen Abdeckplatte 1 entfallen können, wie in den Fig. 5 und 6 dargestellt ist. Den Mikrolinsen 3 sind Fotosensoren 4 zugeordnet, die sich in der Mitte von Subpixeln 5 umfassenden Anzeigepixeln 6 befinden. Die Subpixel 5 können in verschiedenen Farben, vorzugsweise Rot, Grün oder Blau ausgeführt sein bzw. derartig farbiges Licht, auch monochrom, emittieren. Zusätzlich ist auch die Anordnung eines infrarotes Licht emittierenden Subpixels 5 möglich, um die Position des zu scannenden Objekts auch im Dunkeln zu ermitteln. Für besondere Sicherheitsapplikationen können auch UV-Licht emittierende Subpixel 5 vorgesehen sein. Eine beliebige Kombination von Farben ist denkbar. Um den Fotosensor 4 vor einem unmittelbaren Lichteinfall zu schützen, um also zu verhindern, dass das von den Anzeigepixeln 6 emittierte Licht direkt in den Fotosensor 4 eintritt, ist dieser mit einer abschattenden Maske 7, beispielsweise in Form einer Metallisierung, versehen.

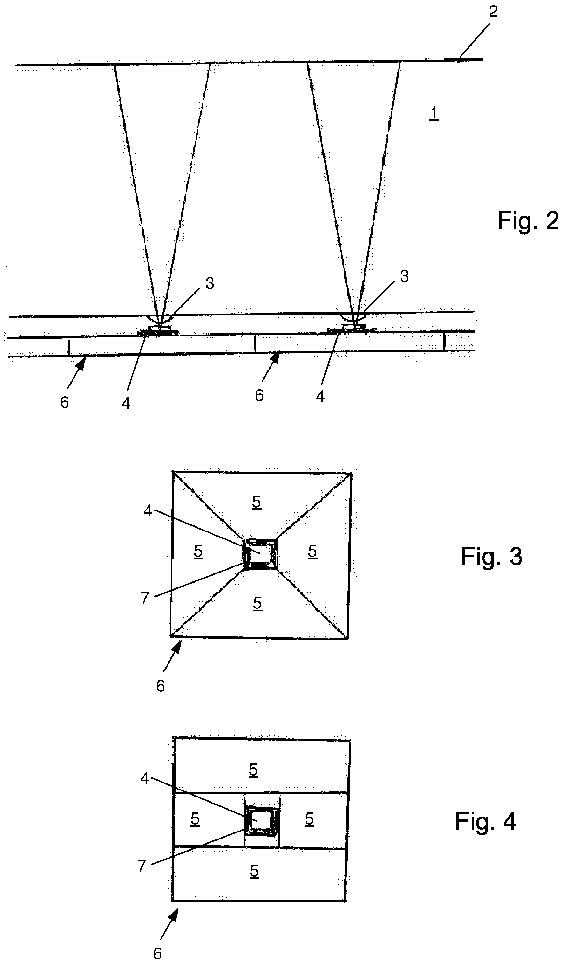

Nach Fig. 2 ist der Fotosensor 4 auf ein Anzeigepixel 6 aufgesetzt, wonach die Bestückung beispielsweise eines OLED-Displays mit Fotosensoren 4 möglich ist.

Den Fig. 3 und 4 ist zu entnehmen, wie der Fotosensor 4 an einem Anzeigepixel 6 bzw. die Subpixel 5 eines Anzeigepixels zu dem Fotosensor 4 zu positionieren sind. Von Wichtigkeit scheint nach bisherigen Erkenntnissen die Anordnung des Fotosensors 4 in der Mitte de Anzeigepixels 6, damit er die Reflexion der durch die Anzeigepixel 6 emittierten Lichtstrahlen unter Abtastwinkel 8 erfasst.

Wie dem Fachmann geläufig ist, werden Helligkeitsänderungen durch die Fotosensoren 4 erfasst, die durch die auf der Abdeckplatte aufgelegten Objekte oder eben fehlende Objekte verursacht werden, wobei die Helligkeitsänderungen aufgrund von Reflexionen verursacht werden.

Die Größe des Abtastbereichs des Fotosensors, also dessen Abtastwinkel ist an die Größe des Anzeigepixels 6 angepasst, wobei die Verhältnisse in Fig. 1 schematisch dargestellt sind. Um nur die Helligkeit des eigenen Anzeigepixels zu messen, darf der Abtastwinkel 8 folgende Größe nicht überschreiten:

$$\alpha \leq 2\arctan(d/4h_1)$$

mit:

$\alpha$      Abtastwinkel 8
d      Kantenlänge des Anzeigepixels 6
$h_1$      Abstand von der Oberseite des Anzeigepixels zur Oberfläche 2 der Abdeckplatte

Diese Größe des durch den Abtastwinkel 8 bestimmten Erfassungsbereichs des Fotosensors 4 entspricht in der virtuellen Spiegelebene 9 der Größe des Anzeigepixels 6.

Eine Überschreitung des Abtastwinkels 8 würde sich negativ auf den Kontrast wirken, bis hin zum Verlust der Möglichkeit des Scannens. Bei einer relativ dicken transparenten Abdeckplatte 1 wird der Abtastwinkel 8 des Fotosensors 4 mittels der Mikrolinse 3 auf das erforderliche Maß eingestellt.

Bei der Verwendung der Vorrichtung als Fingerabdruck-Scanner senden die Anzeigepixel 6 das Licht direkt durch die transparente Abdeckplatte 1 zu deren Oberfläche 2. Die Fotosensoren 4 befinden sich im Schatten der zugeordneten Masken 7 und sind nicht durch die direkte Lichteinstrahlung der Anzeigepixel 4 belichtet. Jeder Fotosensor 4 empfängt unter dem Abtastwinkel 8 das Licht, das von dem ihn umgebenden Anzeigepixel 6 bzw. dessen Subpixeln 5 emittiert wird und das sich an der Oberfläche 2 der Abdeckplatte 1 spiegelt,

In diesem Fall ist die an der Oberfläche 1 reflektierte Lichtmenge davon abhängig, ob ein Finger 11 in Kontakt mit der Oberfläche 2 steht und das Licht in den Finger eingekoppelt ist oder nicht, wie bereits weiter oben und im Folgenden anhand der Darstellung gemäß Fig. 5 erläutert.

Fig. 5 gibt insbesondere nicht die wahren Größenverhältnisse wieder, da einem auf der Abdeckplatte 1 aufliegenden Finger selbstverständlich eine Vielzahl von Anzeigepixeln 6 zugeordnet sind und nicht nur ein Anzeigepixel 6, wie dargestellt.

Das auf der linken Seite dargestellte Anzeigepixel 6.1 sendet einen Lichtstrahl gemäß dem Pfeil 12 zu der Oberfläche 2 der Abdeckplatte 1, an der eine Transition von der Abdeckplatte 1 in die Luft 13 stattfindet, wobei die Brechungsindizes der Abdeckplatte 1 und der Luft 13 sehr unterschiedlich sind. Daher wird in dem Bereich ohne Kontakt mit dem Finger an der Oberfläche 2 viel Licht zu dem zugeordneten Fotosensor 4.1 reflektiert, wie durch den Pfeil 14 dargestellt ist. Ein kleiner Anteil der Lichtstrahlung wird entsprechend dem Pfeil 15 hinter die Oberfläche 2 gesendet.

Das auf der rechten Seite dargestellte Anzeigepixel 6.2 sendet den Lichtstrahl gemäß dem Pfeil 16 zu der Oberfläche 2, an der eine Transition von der Abdeckplatte 1 in den Finger 11 stattfindet, wobei die Brechungsindizes der Abdeckplatte 1 und des Fingers 11 ähnlich sind. Daher wird in dem Bereich, in dem der Finger 11 auf der Oberfläche 2 aufliegt, gemäß dem Pfeil 17 wenig Licht zu dem Fotosensor 4.2 reflektiert. Ein großer Anteil der Lichtstrahlung wird entsprechend dem Pfeil 18 hinter der Oberfläche 2 von dem Finger 11 aufgrund der optischen Ankopplung absorbiert.

Bei der Verwendung als Scanner sendet ein Teil der Anzeigepixel 6, bei denen der Fotosensor 4 nicht aktiv ist, das Licht und Fotosensoren 4 deren Anzeigepixel 6 kein Licht senden, erfassen das an der Oberfläche 2 reflektierte Licht der anderen Anzeigepixel. Eine mögliche Anordnung ist gemäß dem Muster eines Schachbretts, wobei die Licht emittierenden Anzeigepixel 6 mit ausgeschalteten Fotosensoren 4 beispielsweise den weißen Feldern und die eingeschalteten Fotosensoren 4 mit den kein Licht emittierenden Anzeigepixeln 6 den schwarzen Feldern entsprechen oder umgekehrt.

Eine weitere mögliche Anordnung und Ansteuerung ist die wechselweise zeilen- und oder spaltenweise Anordnung der Licht emittierenden Anzeigepixel 6 mit ausgeschalteten Fotosensoren 4 und der kein Licht emittierenden Anzeigepixel 6 mit den aktiven Fotosensoren 4.

In einem ersten Schritt erfassen die aktiven Fotosensoren 4 kein an der Oberfläche 1 reflektiertes Licht des eigenen Anzeigepixels 6, sondern nur reflektiertes Licht des zu scannenden Objekts, das sich auf bzw. hinter der Oberfläche 1 befindet, und das von einem benachbarten Anzeigepixel 6 beleuchtet ist. Es entsteht keine Reflexion von Licht, das von dem dem Fotosensor 4 zugeordneten, also dem eigenen Anzeigepixel an der Oberfläche 1 reflektiert wurde. Eine Antireflex-Vergütung der Oberfläche 1 ist nicht nötig.

In einem zweiten Schritt erfolgt eine Aktivierung der Anzeigepixel 6, die bislang kein Licht emittierten und die zuvor ausgeschalteten Fotosensoren 4 werden aktiviert, sodass zwei Halbbilder entstehen, die summiert die volle Auflösung ermöglichen. Da die Umschaltung mit der Displayfrequenz erfolgt, steht die volle Auflösung praktisch in Echtzeit zur Verfügung.

Fig. 6 stellt die Scan-Funktion im Zusammenhang mit dem der Oberfläche 2 der Abdeckplatte 1 zugeordneten Dokument 10 dar.

Das auf der linken Seite dargestellte Anzeigepixel 6.1, dessen zugeordneten Fotosensor 4.1 nicht aktiv ist, sendet entsprechend dem Pfeil 19 einen Lichtstrahl an die Oberfläche 2, an der gemäß dem Pfeil 20 ein Teil der Lichtstrahlung in Richtung des dem rechten Anzeigepixel 6.2, das kein Licht sendet, zugeordneten Fotosensors 4.2 reflektiert wird, aber über den durch den Abtastwinkel 8 definierten Erfassungsbereich des Fotosensors 4.2 hinaus, weshalb diese reflektierte Lichtstrahlung einen die Messung des Fotosensors 4.2 nicht beeinflussende Störwirkung hat. Ein weiterer Teil des abgestrahlten Lichts durchdringt gemäß dem Pfeil 21 die Oberfläche 2 der Abdeckplatte 1 und wird an dem Dokument 10 gemäß dem Pfeil 22 zu dem Fotosensor 4.2 reflektiert, der die Helligkeit der Oberfläche des Dokuments 10 misst.

Die Verwendung der Vorrichtung als Touch-Screen kann sowohl in dem Modus zur Erkennung eines Fingerabdrucks als auch beim Scannen eines Dokumentes 10 erfolgen und erlaubt eine genaue Positionserfassung einer nicht limitierten Anzahl von Fingern 11 oder Stiften oder dergleichen Gegenstände und bildet ein sogenanntes Multitouch-Display. Sind infrarotes Licht emittierende Subpixel 5 oder Anzeigepixel 6 vorgesehen, dann steht die Positionserkennung unabhängig von der Helligkeit der Anzeigeeinrichtung zur Verfügung.

Im Weiteren funktioniert der Touch-Screen auch im Zusammenhang mit beliebigen Gegenständen, also auch mit Prothesen, und kann Bewegungen von Gegenständen auf der Oberfläche erkennen, sodass bei einer relativ großflächigen Vorrichtung viele Benutzer, die gleichzeitig mit vielen Fingern auf der Oberfläche 1 arbeiten, erkannt werden.

Selbstverständlich sind die Fotosensoren 4, die Anzeigepixel 6 bzw. die Subpixel 5 rechnergesteuert und stehen über den Rechner auch mit einem Speichermodul sowie Schalt- und Umschalteinrichtungen in Verbindung.

Bezugszeichen

1. Abdeckplatte
2. Oberfläche
3. Mikrolinse
4. Fotosensor
5. Subpixel

6.  Anzeigepixel
7.  Maske
8.  Abtastwinkel
9.  Ebene
10. Dokument
11. Finger
12. Pfeil
13. Luft
14. Pfeil
15. Pfeil
16. Pfeil
17. Pfeil
18. Pfeil
19. Pfeil
20. Pfeil
21. Pfeil
22. Pfeil

**Patentansprüche**

1.  Verfahren zur rechnergesteuerten optischen Erfassung eines Fingerabdrucks oder eines Gegenstandes auf einer Oberfläche (2) einer Abdeckplatte (1) eines Bildschirms mit mehreren Fotosensoren (4), die jeweils einem Anzeigepixel (6) zugeordnet sind, wobei die Anzeigepixel (6) Lichtstrahlung emittieren und die Fotosensoren (4) innerhalb eines Abtastwinkels (8) von der Oberfläche (2) reflektierte Lichtstrahlung der Anzeigepixel (6) erfassen, wobei die Größe des durch den Abtastwinkel (8) bestimmten Erfassungsbereich des Fotosensors (4) in der virtuellen Spiegelebene (9) der Größe des Anzeigepixels (6) entspricht und der Abtastwinkel $\alpha$ (8) die Größe $\alpha = 2 \arctan(d/4h_1)$ mit der Kantenlänge d des Anzeigepixels (6) und dem Abstand $h_1$ von der Oberseite des Anzeigepixels (6) zur Oberfläche (2) der Abdeckplatte (1) nicht überschreiten darf, und wobei eine mit dem Rechner gekoppelte Umschalteinrichtung entweder einen Fingerabdruckerkennungs-Modus, in dem sämtliche Anzeigepixel (6) Lichtstrahlung emittieren und deren zugeordneten Fotosensoren (4) reflektierte Lichtstrahlung erfassen, oder einen Scan-Modus, in dem die Anzeigepixel (6) nacheinander schachbrettmusterförmig oder zeilen-/ spaltenförmig ein- und ausgeschaltet werden, um Lichtstrahlung zu emittieren, und die Fotosensoren (4) der jeweils ausgeschalteten Anzeigepixel (6) zum Empfangen der reflektierten Lichtstrahlung einschaltet.

2.  Verfahren nach Anspruch 1, **dadurch gekennzeichnet, dass** zur Aufnahme von zwei zu einem Bild zusammensetzbaren Halbbildern des Gegenstandes die Anzeigepixel (6) nacheinander Lichtstrahlung emittieren oder deren Fotosensoren (4) reflektierte Lichtstrahlung empfangen.

3.  Vorrichtung zur Durchführung des Verfahrens nach Anspruch 1 oder 2 mit mindestens einem Bildschirm, der eine obere optische Abdeckplatte (1) umfasst, unter der mehrere Anzeigepixel (6) als Lichtquellen für das darzustellende Bild angeordnet sind, **dadurch gekennzeichnet, dass** mehreren Anzeigepixeln (6) jeweils mittig ein Fotosensor (4) zugeordnet ist, wobei eine mit dem Rechner gekoppelte Umschalteinrichtung vorgesehen ist, um entweder einen Fingerabdruckerkennungs-Modus, in dem sämtliche Anzeigepixel (6) Lichtstrahlung emittieren und deren zugeordneten Fotosensoren (4) reflektierte Lichtstrahlung erfassen, oder einen Scan-Modus, in dem die Anzeigepixel (6) nacheinander schachbrettmusterförmig ein- und ausgeschaltet werden, um Lichtstrahlung zu emittieren, und die Fotosensoren (4) der jeweils ausgeschalteten Anzeigepixel (6) zum Empfangen der reflektierten Lichtstrahlung eingeschaltet werden.

4.  Vorrichtung nach Anspruch 3, **dadurch gekennzeichnet, dass** die Fotosensoren (4) in einem mittigen Freiraum des zugeordneten Anzeigepixels (6), insbesondere umgeben von Subpixeln (5), oder auf der der Abdeckplatte (1) gegenüberliegenden Seite der Anzeigepixel (6) angeordnet sind, wobei jedes Anzeigepixel (6) mehrere Subpixel (5) umfasst.

5.  Vorrichtung nach Anspruch 3 oder 4, **dadurch gekennzeichnet, dass** mindestens eines der Anzeigepixel (6) oder ein Subpixel (5) des Anzeigepixels (6) Strahlung im Infrarot- oder Ultraviolettbereich emittiert.

6.  Vorrichtung nach einem der Ansprüche 3 bis 5, **dadurch gekennzeichnet, dass** die Anzeigepixel (6) oder Subpixel (5) monochromes oder farbiges Licht emittieren.

7.  Vorrichtung nach einem der Ansprüche 5 bis 8, **dadurch gekennzeichnet, dass** die Anzeigepixel (6) Bestandteile eines OLED sind.

8.  Vorrichtung nach einem der Ansprüche 3 bis 7, **dadurch gekennzeichnet, dass** jeder Fotosensor (4) einen Farbfilter umfasst und/oder jedem Fotosensor (4) eine, insbesondere metallisierte, Maske (7) zur Abschirmung vor einer direkten Beleuchtung durch die Anzeigepixel (6) zugeordnet ist.

9.  Vorrichtung nach einem der Ansprüche 3 bis 7, **dadurch gekennzeichnet, dass** jeder Fotosensor (4) mehrere Sub-Fotosensoren mit jeweils einem Farbfilter umfasst.

10. Vorrichtung nach einem der Ansprüche 3 bis 7, **dadurch gekennzeichnet, dass** jeder Fotosensor (4) oder zumindest einer seiner Sub-Fotosensoren für infrarotes Licht empfindlich ist und/oder einen Infrarot-Filter umfasst.

11. Vorrichtung nach einem der Ansprüche 3 bis 10, **dadurch gekennzeichnet, dass** jedem Fotosensor (4) eine, bevorzugt als Fresnel-Linse oder holografische Linse ausgebildete, Mikrolinse (3) zugeordnet ist.

12. Vorrichtung nach einem der Ansprüche 3 bis 11, **dadurch gekennzeichnet, dass** die Mikrolinse (3) zwischen der Abdeckplatte (1) und dem Fotosensor (4) angeordnet ist.

13. Vorrichtung nach Anspruch 3, **dadurch gekennzeichnet, dass** der Bildschirm als ein Touch-Screen ausgebildet ist.

14. Vorrichtung nach einem der Ansprüche 3 bis 13, **dadurch gekennzeichnet, dass** zumindest die Anzeigepixel (6) und die Fotosensoren (4) mit einer Rechnereinheit und einem Speichermodul verbunden sind.

15. Vorrichtung nach einem der Ansprüche 3 bis 14, **dadurch gekennzeichnet, dass** die Abdeckplatte (1) als eine flexible Kunststofffolie ausgebildet ist.

16. Vorrichtung nach Anspruch 15, **dadurch gekennzeichnet, dass** die Kunststofffolie unbeschichtet, hart beschichtet oder mit einer weiteren Folie, vorzugsweise einer Graphen-Folie, abgedeckt ist, und/oder aus mehreren Lagen Folie besteht.

17. Verwendung der Vorrichtung nach einem der Ansprüche 3 bis 16 als ein Fingerabdrucksensor und/oder ein Dokumentenscanner und/oder ein Touch-Screen für ein Mobiltelefon, ein Smartphone, einen Tablet-Computer und/oder einen stationären Arbeitsbildschirm-Computer.

**Claims**

1. Method for the computer-controlled optical capturing of a fingerprint or an object on a surface (2) of a cover plate (1) of a screen with a plurality of photosensors (4) which are assigned in each case to a display pixel (6), wherein the display pixels (6) emit light radiation and the photosensors (4) capture light radiation from the display pixels (6) reflected by the surface (2) within a scan angle (8), wherein the size of the capturing range of the photosensor (4) that is determined by the scan angle (8) corresponds to the size of the display pixel (6) in the virtual mirror plane (9) and the scan angle $\alpha$ (8) must not exceed the size $\alpha = 2\arctan(d/4h_1)$, with the edge length d of the display pixel (6) and the distance $h_1$ from the upper side of the display pixel (6) to the surface (2) of the cover plate (1), and wherein a switching device that is coupled to the computer either a fingerprint recognition mode, in which all display pixels (6) emit light radiation and the photosensors (4) of which that are assigned thereto capture reflected light radiation, or a scan mode, in which the display pixels (6) are switched on and off sequentially in the pattern of a chessboard or in the form of lines and columns so as to emit light radiation, and switches on the photosensors (4) of the respectively switched-off display pixels (6) to receive the reflected light radiation.

2. Method according to Claim 1, **characterized in that**, for recording two half images of the object that can be combined to form one image, the display pixels (6) sequentially emit light radiation or the photosensors (4) of which receive reflected light radiation.

3. Apparatus for carrying out the method according to Claim 1 or 2, with at least one screen which comprises an upper optical cover plate (1), under which a plurality of display pixels (6) are arranged as light sources for the image to be represented, **characterized in that** a photosensor (4) is assigned in each case in a centered fashion to a plurality of display pixels (6), wherein a switching device that is coupled to the computer is provided in order to either a fingerprint recognition mode, in which all display pixels (6) emit light radiation and the photosensors (4) of which that are assigned thereto capture reflected light radiation, or a scan mode, in which the display pixels (6) are switched on and off sequentially in the pattern of a chessboard so as to emit light radiation, and the photosensors (4) of the respectively switched-off display pixels (6) are switched on to receive the reflected light radiation.

4. Apparatus according to Claim 3, **characterized in that** the photosensors (4) are arranged in a central free space of the associated display pixel (6), in particular surrounded by subpixels (5), or on that side of the display pixels (6) that is opposite the cover plate (1), with each display pixel (6) comprising a plurality of subpixels (5).

5. Apparatus according to Claim 3 or 4, **characterized in that** at least one of the display pixels (6) or a subpixel (5) of the display pixel (6) emits radiation in the infrared or ultraviolet range.

6. Apparatus according to one of Claims 3 to 5, **characterized in that** the display pixels (6) or subpixels (5) emit monochromatic or colored light.

7. Apparatus according to one of Claims 5 to 8, **characterized in that** the display pixels (6) are component parts of an OLED.

**8.** Apparatus according to one of Claims 3 to 7, **characterized in that** each photosensor (4) comprises a color filter and/or each photosensor (4) is assigned a mask (7), in particular a metallized mask, for screening against direct illumination by the display pixels (6).

**9.** Apparatus according to one of Claims 3 to 7, **characterized in that** each photosensor (4) comprises a plurality of sub-photosensors with in each case one color filter.

**10.** Apparatus according to one of Claims 3 to 7, **characterized in that** each photosensor (4) or at least one of its sub-photosensors is sensitive to infrared light and/or comprises an infrared filter.

**11.** Apparatus according to one of Claims 3 to 10, **characterized in that** each photosensor (4) is assigned a microlens (3), preferably configured as a Fresnel lens or a holographic lens.

**12.** Apparatus according to one of Claims 3 to 11, **characterized in that** the microlens (3) is arranged between the cover plate (1) and the photosensor (4).

**13.** Apparatus according to Claim 3, **characterized in that** the screen is configured as a touch screen.

**14.** Apparatus according to one of Claims 3 to 13, **characterized in that** at least the display pixels (6) and the photosensors (4) are connected to a computer unit and a memory module.

**15.** Apparatus according to one of Claims 3 to 14, **characterized in that** the cover plate (1) is configured as a flexible plastic film.

**16.** Apparatus according to Claim 15, **characterized in that** the plastic film is uncoated, hard-coated or covered by a further film, preferably a graphene film, and/or consists of a plurality of layers film.

**17.** Use of the apparatus according to one of Claims 3 to 16 as a fingerprint sensor and/or a document scanner and/or a touch screen for a mobile telephone, a smart phone, a tablet computer and/or a stationary work screen computer.

**Revendications**

**1.** Procédé de détection optique commandée par ordinateur d'une empreinte digitale ou d'un objet sur une surface (2) d'une plaque de recouvrement (1) d'un écran, au moyen de plusieurs photocapteurs (4), dont chacun est associé à un pixel d'affichage (6), dans lequel les pixels d'affichage (6) émettent un rayonnement lumineux et les photocapteurs (4) détectent à l'intérieur d'un angle de balayage (8) le rayonnement lumineux des pixels d'affichage (6) réfléchi par la surface (2), dans lequel la taille de la zone de détection du photocapteur (4) déterminée par l'angle de balayage (8) dans le plan miroir virtuel (9) correspond à la taille du pixel d'affichage (6) et l'angle de balayage $\alpha$ (8) ne doit pas dépasser la taille $\alpha = 2\arctan(d/4h_1)$, où d est la longueur de bord du pixel d'affichage (6) et $h_1$ est la distance de la face supérieure du pixel d'affichage (6) à la surface (2) de la plaque de recouvrement (1), et

1. dans lequel un dispositif de commutation couplé à l'ordinateur active soit un mode de reconnaissance d'empreinte digitale dans lequel tous les pixels d'affichage (6) émettent un rayonnement lumineux et leurs photocapteurs (4) associés détectent un rayonnement lumineux réfléchi, soit un mode de balayage dans lequel les pixels d'affichage (6) sont successivement activés et désactivés selon un motif en damier ou sous forme de ligne/colonne afin d'émettre un rayonnement lumineux, et les photocapteurs (4) des pixels d'affichage respectivement désactivés (6) sont activés pour recevoir le rayonnement lumineux réfléchi.

**2.** Procédé selon la revendication 1, **caractérisé en ce que** les pixels d'affichage (6) émettent successivement un rayonnement lumineux ou **en ce que** leurs photocapteurs (4) reçoivent un rayonnement lumineux réfléchi pour l'acquisition de deux demi-images de l'objet qui peuvent être combinées en une image.

**3.** Dispositif pour la mise en oeuvre du procédé selon la revendication 1 ou 2, comportant au moins un écran qui comprend une plaque de recouvrement optique supérieure (1) sous laquelle sont disposés une pluralité de pixels d'affichage (6) en tant que sources de lumière pour l'image à afficher, **caractérisé en ce qu'**un photocapteur (4) est associé de manière centrale à une pluralité de pixels d'affichage (6), dans lequel il est prévu un dispositif de commutation couplé à l'ordinateur pour soit un mode de reconnaissance d'empreinte digitale dans lequel tous les pixels d'affichage (6) émettent un rayonnement lumineux et leurs photocapteurs (4) associés détectent un rayonnement lumineux réfléchi, soit un mode de balayage dans lequel les pixels d'affichage (6) sont successivement activés et désactivés selon un motif en damier afin d'émettre un rayonnement lumineux, et les photocapteurs (4) des pixels d'affichage respectivement désactivés (6) sont activés pour recevoir le rayonnement lumineux réfléchi.

**4.** Dispositif selon la revendication 3, **caractérisé en ce que** les photocapteurs (4) sont disposés dans un espace libre central du pixel d'affichage associé (6), en particulier entouré de sous-pixels (5), ou sur la face des pixels d'affichage (6) qui est opposée à la plaque de recouvrement (1), dans lequel chaque pixel d'affichage (6) comprend une pluralité de sous-pixels (5) .

**5.** Dispositif selon la revendication 3 ou 4, **caractérisé en ce qu'**au moins l'un des pixels d'affichage (6) ou un sous-pixel (5) du pixel d'affichage (6) émet un rayonnement dans le domaine infrarouge ou ultraviolet.

**6.** Dispositif selon l'une quelconque des revendications 3 à 5, **caractérisé en ce que** les pixels d'affichage (6) ou les sous-pixels (5) émettent une lumière monochromatique ou colorée.

**7.** Dispositif selon l'une des revendications 5 à 8, **caractérisé en ce que** les pixels d'affichage (6) sont des composants d'une OLED.

**8.** Dispositif selon l'une des revendications 3 à 7, **caractérisé en ce que** chaque photocapteur (4) comprend un filtre coloré et/ou **en ce qu'**un masque (7), en particulier métallisé, est associé à chaque photocapteur (4) pour la protection contre un éclairage direct par les pixels d'affichage (6).

**9.** Dispositif selon l'une des revendications 3 à 7, **caractérisé en ce que** chaque photocapteur (4) comprend une pluralité de sous-photocapteurs comportant chacun un filtre coloré.

**10.** Dispositif selon l'une des revendications 3 à 7, **caractérisé en ce que** chaque photocapteur (4) ou au moins l'un de ses sous-photocapteurs est sensible à la lumière infrarouge et/ou comprend un filtre infrarouge.

**11.** Dispositif selon l'une des revendications 3 à 10, **caractérisé en ce que** chaque photocapteur (4) est associé à une microlentille (3), de préférence sous la forme d'une lentille de Fresnel ou d'une lentille holographique.

**12.** Dispositif selon l'une des revendications 3 à 11, **caractérisé en ce que** la microlentille (3) est disposée entre la plaque de recouvrement (1) et le photocapteur (4) .

**13.** Dispositif selon la revendication 3, **caractérisé en ce que** l'écran est réalisé sous la forme d'un écran tactile.

**14.** Dispositif selon l'une des revendications 3 à 13, **caractérisé en ce qu'**au moins les pixels d'affichage (6) et les photocapteurs (4) sont reliés à une unité informatique et à un module de mémoire.

**15.** Dispositif selon l'une des revendications 3 à 14, **caractérisé en ce que** la plaque de recouvrement (1) est réalisée sous la forme d'un film plastique flexible.

**16.** Dispositif selon la revendication 15, **caractérisé en ce que** le film plastique est non revêtu, revêtu d'une couche dure ou recouvert d'un autre film, de préférence d'un film de graphène et/ou est constitué de plusieurs couches film.

**17.** Utilisation de l'appareil selon l'une des revendications 3 à 16 en tant que capteur d'empreinte digitale et/ou que numériseur de documents et/ou qu'écran tactile pour un téléphone mobile, un téléphone intelligent, un ordinateur tablette et/ou un ordinateur à écran de travail stationnaire.

Fig. 1

Fig. 2

Fig. 3

Fig. 4

Fig. 5

Fig. 6

**EP 3 008 662 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1158775 A1
- US 20040252867 A1

- DE 69920126 T2